# EUROPÄISCHE PATENTANMELDUNG

(11) **EP 1 691 310 A2**
(43) Veröffentlichungstag der Anmeldung: **16.08.2006**
(21) Anmeldenummer: 05009747.6
(22) Anmeldetag: 04.05.2005
(51) Int. Cl.: G06F 17/50

(54) **Verfahren zur Herstellung eines komplexen technischen Systems**

(30) Priorität: 12.02.2005 DE 102005006428
(71) Anmelder: DaimlerChrysler AG, 70567 Stuttgart (DE)
(72) Erfinder: Belschner, Ralf, Dr., 72124 Pliezhausen (DE); Mrossko, Markus, 70372 Stuttgart (DE); Freess, Jascha, 71404 Korb (DE)

(57) **Zusammenfassung**

Verfahren zur Herstellung eines komplexen technischen Systems in einem Verkehrsmittel, bei dem in einem ersten Schritt für jede Komponente (8, 9) deren technische Komponentenzustände (14, 15) definiert werden und daraus ein Gesamtmodell erzeugt wird, in dem alle Zustände (14, 15) für alle Komponenten (8, 9) abgelegt sind, bei dem in einem weiteren Schritt für jede Komponente (8, 9) ein Einbauraum (17) innerhalb des Verkehrsmittels festgelegt wird und die elektronischen Bauteile der Komponente (8, 9) festgelegt werden, wobei daraus ein Gesamtarchitekturmodell (18) für die Elektronikarchitektur im Verkehrsmittel entsteht und jeder Komponente (8, 9) bestimmte elektrische/elektronische Bauteile, deren Einbauraum (17) und deren Komponentenzustände (14, 15) zugewiesen werden, dadurch gekennzeichnet, dass zusätzlich die elektrische Verkabelung (19) der elektrischen Bauteile (8, 9) der Komponenten und deren Schnittstellen festgelegt werden und dass für das Gesamtarchitekturmodell (18) bei Verlagerung einer Komponente (8, 9) in einen anderen Bauraum des Verkehrsmittels oder bei Änderung des Umfangs der Komponentenzustände (14, 15) einer Komponente die notwendigen Signalübertragungsvorgänge zwischen den Komponenten berechnet werden.

## Beschreibung

Die Erfindung betrifft ein Verfahren zur Herstellung eines komplexen technischen Systems in einem Verkehrsmittel, bei dem in einem ersten Schritt für jede Komponente deren technische Komponentenzustände definiert werden und daraus ein Gesamtmodell erzeugt wird, in dem alle Zustände für alle Komponenten abgelegt sind. In einem weiteren Schritt wird für jede Komponente ein Einbauraum innerhalb des Verkehrsmittels festgelegt und die elektronischen Bauteile der Komponente werden zugeordnet, wobei daraus ein Gesamtarchitekturmodell für die Elektronikarchitektur im Verkehrsmittel entsteht und jeder Komponente bestimmte elektrische/elektronische Bauteile, deren Einbauraum und deren Komponentenzustände zugewiesen werden.

Technische Systeme im Verkehrsmittel werden durch viele unterschiedliche Firmen entwickelt und später beim Fahrzeughersteller im Verkehrsmittel verbaut. Durch die Vernetzung der Einzelsysteme wirken sich technische Veränderungen einer ersten Komponente meist auf eine Vielzahl von anderen Bauteilen ebenfalls aus. Dies kann einerseits in Form von Veränderungen durch Neuinitialisierung oder Parametrisierung der anderen Komponenten erfolgen oder auch dadurch, dass eine überarbeitete Hardware-Architektur bei anderen Komponenten erforderlich ist. Die Komplexität, aber auch die zeitlichen Erfordernisse haben bereits in der Vergangenheit dazu geführt, dass einzelne Software-/Hardware-Entwicklungssysteme eingeführt wurden, in denen beispielsweise aufgrund der erforderlichen Zustände einer Komponente eine Merkmalsliste erzeugt wird, und aufgrund dieser Merkmalsliste ein Flussdiagramm, Strukturgramm oder auch eine compilierfähige Software erzeugt wurde.

Weitere Hardware-Entwicklungssysteme ermöglichen aufgrund der bekannten Komponentenstruktur automatisch deren Vernetzung bzw. deren leitungsmäßigen Verbund im Verkehrsmittel zu erstellen bzw. zu optimieren. Derartige Entwicklungssysteme sind unter "DOORS", "XDIS", "DaVinci" bekannt.

Beim Verkehrsmittel besteht nun das Problem, dass nicht nur Komponenten technisch weiterentwickelt werden, sondern dass Komponenten innerhalb des Verkehrsmittels in andere Bauräume eingebaut werden. Dies hat meist Folgen in Bezug auf die Vernetzung, die Verkabelung und auch auf die Software-Module, die diese Komponenten ansteuern. Bisher führt dieses Erfordernis dazu, dass in den einzeln voneinander unabhängigen Entwicklungssystemen zunächst die Vernetzung, in einem weiteren Entwicklungssystem die Leitungsverteilung und in den weiteren Systemen daraufhin die Software und die neu hinzugekommenen Merkmale bzw. entfallenen Merkmale angepasst werden müssen. Sämtliche Ergebnisprotokolle der einzelnen Entwicklungssysteme müssen danach manuell zusammengeführt werden, so dass insbesondere bei der Auswertung von Gesamtsystemen der Aufwand sehr hoch ist.

Es ist Aufgabe der vorliegenden Erfindung, ein Verfahren zur Herstellung eines komplexen technischen Systems derart zu verbessern, dass bei Verlagerung von einzelnen Komponenten in neue Einbauräume die sich daraus ergebenden Änderungen bzgl. der Elektronikarchitektur automatisiert entwickelt bzw. berechnet wird.

Diese Aufgabe wird durch die Merkmale des Anspruchs 1 gelöst. Danach wird bei dem Verfahren eine zusätzliche elektrische Verkabelung der elektrischen Bauteile der Komponente und deren Schnittstellen festgelegt und das Gesamtarchitekturmodell bei Verlagerung einer Komponente in einen anderen Bauraum des Verkehrsmittels oder bei Änderung des Umfangs der Komponentenzustände einer Komponente werden die notwendigen Signalübertragungsvorgänge zwischen den Komponenten berechnet. Gemäß dem unabhängigen Anspruch 2 werden beim Verfahren zur Herstellung eines komplexen technischen Systems zusätzlich die elektrische Verkabelung der einzelnen Bauteile der Komponente und deren Schnittstellen festgelegt und das Gesamtarchitekturmodell wird im Grundriss des Verkehrsmittels dargestellt, wobei das Gesamtarchitekturmodell bei Verlagerung einer Komponente in einen anderen Bauraum des Verkehrsmittels oder bei Änderung des Umfangs der Komponentenzustände einer Komponente die bzgl. der architektonischen Anordnung der elektronischen Bauteile notwendigen Veränderungen berechnet bzw. optimiert.

Das Verfahren der vorliegenden Erfindung besteht aus einer Verkettung einzelner Entwicklungssysteme und ist derart ausgelegt, dass bei Verlagerung einer Einzelkomponente automatisch deren Erfordernisse bzgl. Einbauraum, Vernetzung, Verkabelung, Parametrisierung und bzgl. neuer Software-Module überprüft werden. Es ist eine besondere Herausforderung, in der Konzeptphase der Elektrik-/Elektronik-Architektur innerhalb eines Verkehrsmittels die passende Elektrik-/Elektronik-Architektur bereitzustellen. Während der gesamten Entwicklungsphase des Verkehrsmittels ist diese sog. EE-Architektur vielfältigen Änderungen unterworfen. In Bezug auf Kosten, Baumaße, Gewicht und Qualität wird die EE-Architektur des Fahrzeugs in der Entwicklungsphase mehrfach verändert. Das Verfahren der vorliegenden Erfindung unterstützt die Entwickler des Verkehrsmittels bei der Wahl der richtigen EE-Architektur und ermöglicht eine schnelle und objektive Bewertung der unterschiedlichen Möglichkeiten.

Das erfindungsgemäße Verfahren beschreibt zunächst die EE-Architektur innerhalb des Verkehrsmittels in allen einzelnen Komponenten und deren gegenseitigen elektronischen Abhängigkeiten und erstellt daraus ein Gesamtarchitekturmodell, wobei die Vernetzungs-Topologie, die Komponentenfunktionen und die Leitungssatz-Verbindungen zu den einzelnen Komponenten modelliert werden. In einem ersten Schritt wird das Gesamtarchitekturmodell hinsichtlich vollständiger Vernetzung, dem Vorhandensein der notwendigen Stromversorgungsleitungen und der Zuordnung der einzelnen Funktionen zu den spezifischen Komponenten geprüft.

Bei dem Verfahren wird zunächst eine Merkmalsliste erzeugt, bei dem das Gesamtarchitekturmodell in einzelne Funktionsmodelle zerlegt wird, beispielsweise in ein Funktionsmodell Fahrzeug-Innenraum-Ansteuerung, Fahrzeug-Motor-/Getriebe-Ansteuerung oder Fahrzeug-Beleuchtungs-Ansteuerung. Für jedes dieser Funktionsmodelle werden die erforderlichen Merkmale beschrieben, beispielsweise Licht an, Licht automatisch an, Licht aus, Standlicht, Bremslicht usw.. Diese einzelnen Funktionen werden den zugehörenden EE-Komponenten zugeordnet. Aufgrund der so erzeugten Merkmale wird zu den bereits definierten Komponenten, wie Lichtsteuergerät, Motorsteuergerät usw., der zugehörende Leitungssatz und die zugehörende Vernetzung, beispielsweise CAN-Datenbus, Stromversorgung, erzeugt. In einem weiteren Schritt wird jeder EE-Komponente zugewiesen, welche Daten erforderlich sind und von welcher anderen Komponente diese Daten erhalten werden. Aufgrund dieser Datenbeziehung errechnet das Verfahren zur Herstellung eines komplexen technischen Systems automatisch die notwendige Vernetzung und kann bzgl. des Datenbusses auch bestimmen, welche Mindestanforderungen an Nachrichten auf dem Datenbus erforderlich sind.

Bei dem Verfahren zur Herstellung eines komplexen technischen Systems wird das Gesamtarchitekturmodell dem Grundriss des Verkehrsmittels derart zugeordnet, dass jedes Bauteil durch Verschieben auf dem Bildschirm eines Rechners mittels einer Maus oder einer anderen Visualisierungseinrichtung exakt dem Bauraum innerhalb des Verkehrsmittels zugeordnet wird. Dadurch entsteht über dem Grundriss des Verkehrsmittels eine eindeutige Zuordnung der Komponenten und der zugehörenden Vernetzung bezogen auf das EE-Gesamtarchitekturmodell. Wird nun in einer späteren Entwicklungsphase die Funktionalität einer Komponente in eine andere Komponente übernommen, so berechnet das Verfahren zur Herstellung eines komplexen technischen Systems automatisch die erforderlichen Daten für die geänderte Komponente aufgrund Addition der erforderlichen Daten aus beiden Komponenten, die Vernetzung wird angepasst und die Nachrichtenformate für die neu entstandene Komponente wird durch Addition aus den alten Nachrichtenformaten erstellt.

Das Verfahren zur Herstellung einer komplexen technischen Komponente wird auf einem vernetzten Rechnersystem im Entwicklungsbereich eines Fahrzeugherstellers betrieben und weist entsprechende Editoren zur Darstellung der Einzelschritte des Verfahrens dar. Es lassen sich Funktions-, Kommunikations-, Vernetzungs- und Komponentendiagramme erzeugen. Eine Topologieverteilung bzw. das Boardnetz lassen sich ebenfalls auf diesem Editor, jeweils mit den erforderlichen Komponenten, Merkmalen und Verbindungen darstellen. Bei Veränderungen im Gesamtsystem werden automatisch die entsprechenden Diagramme angepasst, so dass die daraus entstehenden Erfordernisse vom einzelnen Entwickler innerhalb des vernetzten Systems abgerufen werden können. Auf diese Weise können viele Entwicklungsingenieure in einem komplexen technischen System arbeiten und es werden bei einer Veränderung im komplexen technischen System an einer Stelle die Veränderungen sofort im Gesamtsystem umgesetzt, so dass jeder Entwickler immer den neuesten Zustand des Entwicklungssystems kennt.

Das Verfahren zur Herstellung eines komplexen technischen Systems unterstützt den EE-Architekturprozess bei einem Verkehrsmittelhersteller derart, dass bestimmte Module oder das Gesamtsystem auch bei einem Zulieferer bereitgestellt werden kann. Dabei können bei Zulieferer lediglich die für diesen interessanten Bereiche der EE-Gesamtarchitektur und deren notwendigen Schnittstellen bereitgestellt werden. Über ein Synchronisierungsverfahren kann dann bei nachträglichen Veränderungen jeweils die Auswirkungen auf die Schnittstelle und auf die den Zulieferer betreffenden EE-Architekturpunkte in der Darstellung übernommen werden.

Das Verfahren zur Herstellung eines komplexen technischen Systems kann beispielsweise bei der Außenbeleuchtung des Verkehrsmittels angewendet werden. Im Gesamtarchitekturmodell werden dann die Positionierung der einzelnen Lichtquellen im Grundriss des Verkehrsmittels und die Positionierung der zugehörenden elektronischen Komponenten und Steuergeräte durchgeführt. In einem weiteren Schritt werden die einzelnen Merkmale der Lichtquellen, die Verkabelung/Vernetzung der Bauteile und die Vernetzung der Steuergeräte untereinander berechnet und die zugehörenden elektrischen und/oder informationstechnischen Signale optimiert. Wird nun bei späterer Veränderung in der EE-Architektur eine Komponente hinzugefügt, beispielsweise ein Notfalllicht, werden die für jedes Übertragungsmedium der Verkabelung insbesondere im Datenbus, Leitungen u. a., notwendigen Signale erzeugt und für jede Leitung, für jeden Datenbus wird ein Schwellwert für die Anzahl der zu übertragenden Signale bzw. die Grenzen bzgl. Spannung oder Strom auf einer Leitung diesem Übertragungsmedium zugeordnet. Wenn sich durch die Veränderung eine erhöhte Übertragung von Signalen oder eine steigende Stromversorgungsleistung auf den Leitungen ergibt, berechnet das Verfahren automatisch die Anzahl der Nachrichten oder Stromwerte und vergleicht sie mit einem jeder Leitung zugeordneten Schwellwert. Bei Überschreiten des Schwellwerts wird das System automatisch einen weiteren Signalweg erzeugen und eine bestimmte Anzahl von Nachrichten bzw. Signalen über den neuen Signalweg zuordnen. Außerdem wird bei diesem Vorgang eine Fehlermeldung für den Entwickler erzeugt, so dass dieser sich mit der Thematik befassen kann.

Das Verfahren zur Herstellung eines komplexen technischen Systems bildet den technischen Entwicklungsprozess für eine EE-Architektur im Verkehrsmittel ab. In einer ersten Phase wird die EE-Architektur entsprechend den Einbauräumen organisiert, wobei die Geometrie des Verkehrsmittels in Form des Grundrisses oder auch einer anderen Darstellung, wie ein Aufriss oder eine Explosionsdarstellung, vorgesehen wird. Dazu können aus dem Rohbau des Verkehrsmittels bestimmte Daten in dem Verfahren berücksichtigt werden, dazu können beispielsweise die Geometrie des Chassis, die Einbauräume für die Kabelsätze und freie Einbauräume im Verkehrsmittel beim Verfahren berücksichtigt werden und die Komponenten optimiert eingeplant werden. In einem weiteren Schritt werden in verschiedenen Komponenten die Lieferanten zugewiesen und die Systeme werden entsprechend des Lieferumfangs getrennt behandelt, so dass Schnittstellten zu den unterschiedlichen Teilsystemen berechnet werden können, wodurch dann jedem Lieferanten oder Zulieferer lediglich das für ihn notwendige Teilsystem zur Verifizierung der eigenen EE-Architektur übergeben werden kann.

In einem weiteren Schritt werden beim Verfahren in einem Funktionseditor für jedes Bauteil dessen Merkmale und die erforderlichen Funktionen zugeordnet. In einem Vernetzungseditor wird quasi wie beim Auto-Router die notwendige Vernetzung, die sich aus den Funktionen und Merkmalen der Komponenten ergibt, automatisch aufgebaut und dann hinsichtlich der Leitungswege aber auch der Nachrichtendichte optimiert werden. Beispielsweise kann bei einem Datenbus von vornherein das Aufkommen der Nachrichten mit berücksichtigt werden und gegebenenfalls eine verbesserte Auslegung von Anfang an eingeplant werden.

In einem Topologie-Editor werden dann die bereits beschriebenen noch freien Einbauräume im Verkehrsmittel den einzelnen Komponenten zugeordnet, so dass dann bei dem Verfahren jeweils die entsprechende Leitungslänge der Verkabelung und der Bussysteme exakt berechenbar ist, da der Einbauort der Komponenten bestimmt ist.

Mittels eines Schaltplaneditors kann bei dem Verfahren zur Herstellung eines komplexen technischen Systems eine vordefinierte Komponente in die EE-Architektur mit eingebunden werden, wobei hier lediglich die Merkmale, deren Funktionen und die Schnittstelle zwischen den beiden Systemen, nämlich der bestehenden EE-Architektur und der neu dazukommenden Komponente, beschrieben werden müssen. Aufgrund des Verfahrens lassen sich schon im Entwicklungsprozess Leitungslängen und Leitungsgewichte, Kosten und ein Komponentensteckbrief erzeugen. Ferner lassen sich die Schnittstellen derart genau definieren und Teilsysteme exportieren, so dass jedem Zulieferer eine zugeordnete EE-Architektur übergeben werden kann. Insbesondere bei Verlagerung von Komponenten errechnet das System automatisch zum neuen Einbauort die notwendige Kabellänge und die gegebenenfalls wegfallenden Funktionen zu. Aus dem System lassen sich für die Entwicklung bestimmte Beschreibungen der EE-Architektur exportieren. Dazu gehört eine Boardnetzbeschreibung, die sowohl die Datenbusvernetzung als auch den Leitungssatz beschreibt. Ferner gehört die Steuergeräte-Topologie und die Gesamtsystembeschreibung zu den exportierfähigen Formaten.

Das Verfahren zur Herstellung eines komplexen technischen Systems kann in Form einer integrierten Entwicklungsplattform mittels Software-Modulen ausgebildet sein, indem die Modellierung der elektronischen/elektrischen Architektur mit den einzelnen Komponenten und Steuergeräten erfolgen kann, es erfolgt eine semantische Verlinkung der einzelnen Komponenten und aufgrund der Merkmale und Funktionen der Komponenten erfolgt eine Vernetzung innerhalb der EE-Architektur. Schließlich kann eine Beschreibung jeder einzelnen Komponente exportiert werden. Die integrierte Entwicklungsplattform weist mehrere isolierte Entwicklungswerkzeuge auf, d. h. modellbasierte Entwicklungsumgebung oder eine Einheit zur Optimierung der Vernetzung, wobei ein Vorteil des Verfahrens darin besteht, dass bei Veränderung einzelner Komponenten im Gesamtsystem die Daten nachgeführt werden und das System auf die neue Veränderung optimiert wird.

Das erfindungsgemäße Verfahren wird nun im Zusammenhang mit verschiedenen Ausführungsformen näher beschrieben. Die Vorteile und Weiterbildungen ergeben sich aus der Beschreibung und den zugehörenden Ansprüchen. Es zeigen in schematischer Darstellung,
- Fig. 1: ein Diagramm, in dem Entwicklungsplattformen nach dem Stand der Technik dargestellt sind,
- Fig. 2: eine Benutzeroberfläche der erfindungsgemäßen Entwicklungssoftware zur Durchführung eines Verfahrens zur Herstellung eines komplexen technischen Systems,
- Fig. 3: eine schematische Darstellung der Verfahrensschritte beim erfindungsgemäßen Verfahren,
- Fig. 4: eine mittels des erfindungsgemäßen Verfahrens entwickelte EE-Architektur und
- Fig. 5: eine Darstellung des mit dem Verfahren zur Herstellung eines komplexen technischen Systems durchzuführenden EE-Architektur-Entwicklungsprozesses.

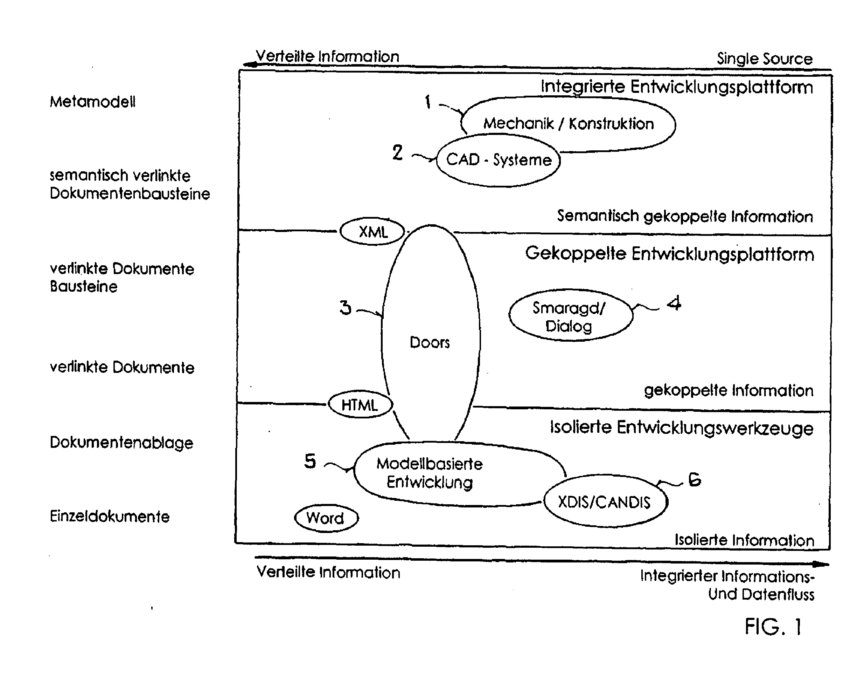

In Fig. 1 sind verschiedene Entwicklungsplattformen nach dem Stand der Technik entsprechend ihrer Informationsverteilung und den Entwicklungsfunktionen gegliedert. Als erste integrierte Entwicklungsplattform können Konstruktionsprogramm zur mechanischen Entwicklung 1 und CAD-Systeme 2 angesehen werden. Die Daten werden dabei gemäß der mechanischen Anforderungen an die zu entwickelnde Komponente im CAD-System 2 eingegeben und daraus die entsprechende Komponente entwickelt. Im CAD-System 2 sind dabei Metamodelle, d. h. Ansichten der zu entwickelnden Komponente aus verschiedenen Richtungen und unter verschiedenen Bedingungen, hinterlegt. Aufgrund der Eingabe mittels semantischer Informationen können in der mechanischen Konstruktions- und Entwicklungsplattform 1 bzw. im CAD-System 2 semantisch verlinkte Dokumentbausteine entstehen, die dann bei der weiteren Entwicklung berücksichtigt werden können, indem die einzelnen Daten aus dem CAD-System 2 exportiert werden und diese Daten gegebenenfalls konvertiert und in eine weitere Entwicklungsplattform eingelesen werden können.

Im Stand der Technik sind bereits gekoppelte Entwicklungsplattformen von verschiedenen Firmen unter den Begriffen "DOORS" 3, "Smaragd" 4 oder "Dialog" 4, um nur einige zu nennen, bekannt. Dabei werden Bausteine in separaten Entwicklungsumgebungen entwickelt und die daraus extrahierten Daten können jeweils in der anderen Entwicklungsumgebung weiterverwendet werden. Es können dabei gekoppelte bzw. verlinkte Informationen in Dokumenten abgelegt werden, so dass jede Entwicklungsumgebung auf diese Daten, beispielsweise Bemaßungen, Spannungswerte oder Leistungsaufnahmen oder auch Bauteiltypen eingegeben werden. Die zur Beschreibung verwendete technische Beschreibungssprache ist bevorzugt eine HTML- oder eine XML-Beschreibungssprache. Mittels dieser technischen Sprachen lassen sich bestimmte Funktionen von Komponenten und Baugruppen beschreiben und in einer anderen Entwicklungsumgebung weiterverwenden.

Schließlich sind noch isolierte Entwicklungswerkzeuge aus dem Stand der Technik bekannt, sog. modellbasierte Entwicklungsumgebungen 5 beispielsweise "XDIS" oder "CANDIS" oder andere Entwicklungswerkzeuge. Dabei werden in dem System isolierte Informationen beispielsweise in Word unter einer bestimmten Beschreibungsformatsprache abgelegt, wobei diese Einzeldokumente dann umständlich konvertiert oder eben in dafür vorgesehene Programme importiert werden müssen. Mit diesen bekannten Entwicklungsplattformen 1 bis 5 können EE-Architekturen innerhalb eines Verkehrsmittels bezogen auf eine bestimmte Funktion beschrieben und konstruiert werden, wobei zur Darstellung der Gesamtarchitektur jeweils mehrere Entwicklungsplattformen notwendig sind. Deswegen ist es bei komplexen technischen Systemen zeitaufwendig und kompliziert, die verschiedenen Wechselwirkungen der einzelnen Architekturen untereinander nachzuvollziehen, wenn beispielsweise eine Komponente in einen neuen Bauraum verlagert wird oder eben Merkmale und Funktion einer Komponente reduziert oder vergrößert werden.

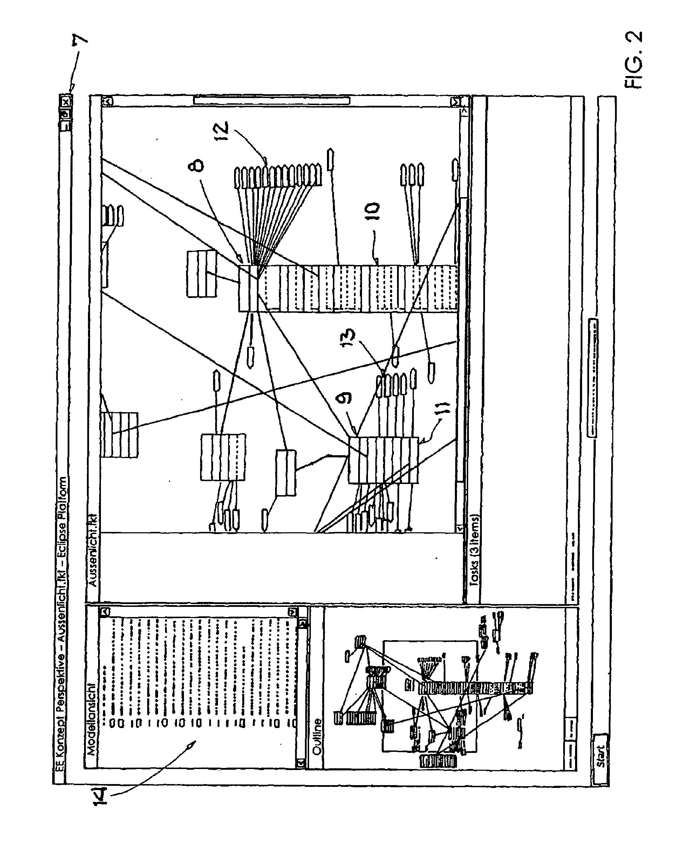

In Fig. 2 ist eine Benutzeroberfläche 7 des erfindungsgemäßen Verfahrens zur Herstellung eines komplexen technischen Systems in einem Verkehrsmittel dargestellt. Es handelt sich dabei um eine modellbasierte Eingabe der einzelnen Elektronik-Architekturkomponenten 8, 9 mit den jeweils dazu beschriebenen Funktionen 10 und 11 und den unterschiedlichen Schnittstellen zu weiteren Komponenten 12 und 13. Diese Benutzeroberfläche 7 stellt eine erste Entwicklungsumgebung zur Darstellung einer Gesamtarchitektur entsprechend einer ersten Entwicklungsumgebung in einem Verkehrsmittel dar. Über die Benutzeroberfläche 7 lässt sich beispielsweise über eine Merkmalsliste 14 für jede Komponente oder Baugruppe 8, 9 festlegen, welche Merkmale 14 der jeweiligen Komponente 8 oder 9 zugeordnet wird.

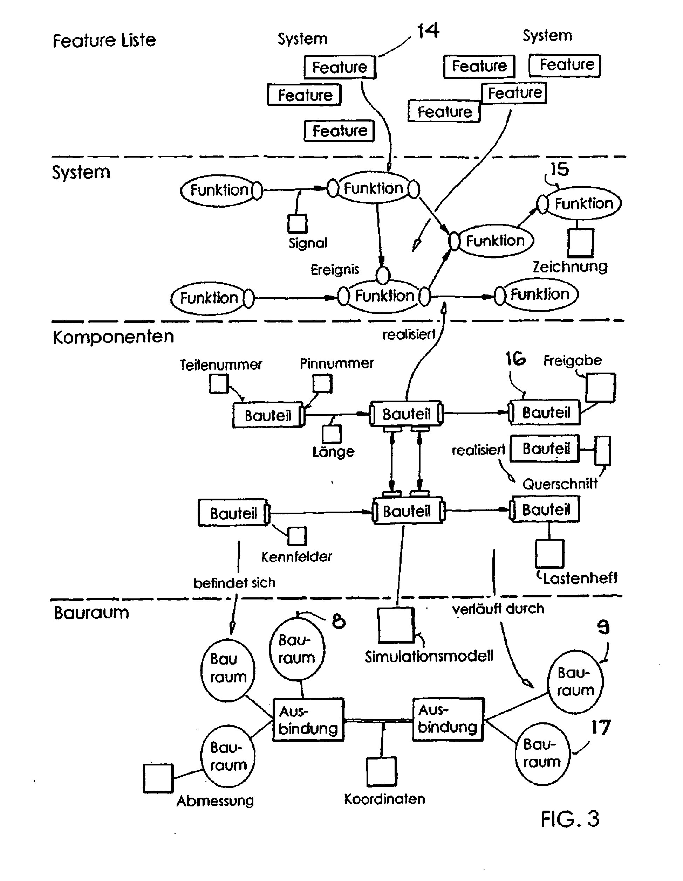

Wie in Fig. 3 dargestellt ist, lässt sich die Merkmalsliste 14 bzw. Feature-Liste nacheinander für jede Komponente des Gesamtarchitekturmodells aufbauen. In einem weiteren Schritt werden jeder Komponente die verschiedenen Funktionen, die diese durchführen muss, zugeordnet. Die Funktionen 15 beschreiben beispielsweise für ein Steuergerät, dass ein Licht einschalten und ein Licht ausschalten möglich ist. Im Gegensatz dazu beschreibt ein Merkmal 14 für die Komponente beispielsweise die Leistungserfordernisse bzgl. der elektrischen Stromversorgung, die Stärke des Lichts, der dafür notwendige Lampentyp usw. Wenn die Merkmale und die Funktion für jede Baugruppe, d. h. für die Motorsteuerung, für die Fahrdynamiksysteme wie ABS, ESP, ARS u. a. und auch für die elektronischen Komfort-Komponenten im Innenraum des Fahrzeugs angegeben sind, werden die Komponenten in ihrer elektrischen Ausgestaltung mittels Schaltplänen bei 16 beschrieben. Dabei wird detailliert auf die elektronischen Komponenten eingegangen, wobei der Typ und die Beschaltung modelliert werden, so dass für jedes Bauteil eine eigene Bauteilmodellierung entsteht. Schließlich wird jedem Bauteil, der im Verkehrsmittel vorgesehene Bauraum 17 zugeordnet. Das heißt, dass für die Komponenten 8 und 9 im Fahrzeug neben der Merkmalsliste 14, der Funktionsbeschreibung 15 und der eigentlichen elektronischen Komponentenausstattung 16 eine exakte Bauraumzuordnung erfolgt. Diese Beschreibung wird dann mittels einer technischen Beschreibungssprache wie XML, UML oder HTML bei dem Verfahren zur Herstellung eines komplexen technischen Systems abgespeichert und für die Berechnungen des Entwicklungssystems verwendet.

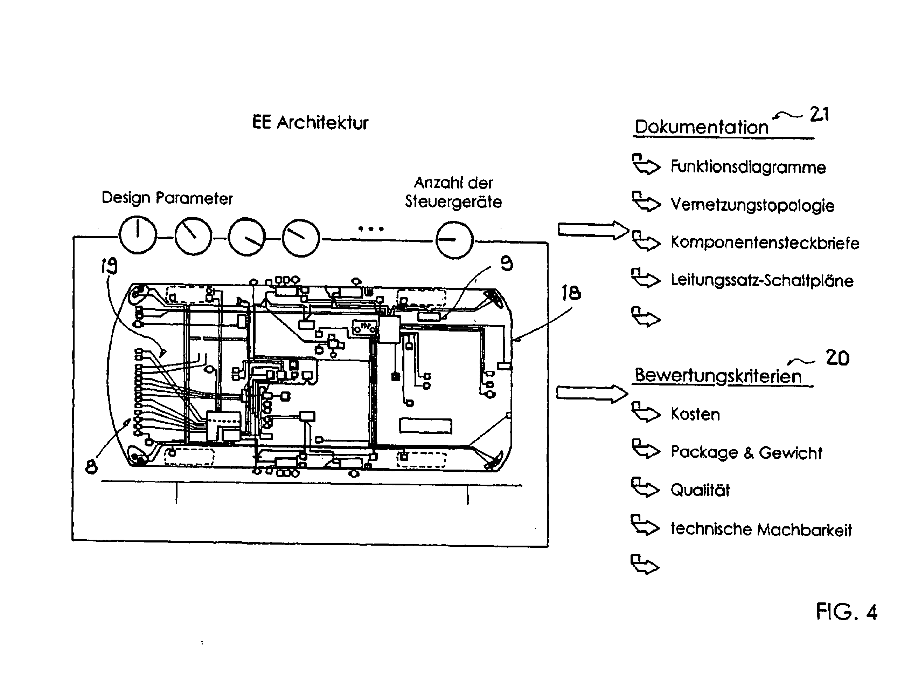

Wie in Fig. 4 dargestellt erfolgt über dem Grundriss 18 des Verkehrsmittels eine bauraumgenaue Darstellung der einzelnen Bauteile 8, 9. Bei dem Verfahren zur Herstellung eines komplexen technischen Systems wird dazu auch die elektrische Verbindung 19 zwischen den einzelnen Komponenten berechnet und je nach Wunsch mittels bestimmter Designparameter verdrahtet. Das Verfahren berücksichtigt dazu die vorgegebene Anzahl der Steuergeräte und Bewertungskriterien 20, wobei Kosten, die Packages und das Gewicht der einzelnen Bauteile und eine technische Machbarkeitsprüfung vorgesehen werden. Zusätzlich zu dem technischen Entwicklungsverfahren kann bei 21 die gesamte Entwicklungsphase mittels Funktionsdiagrammen, einer Vernetzungs-Topologie, Komponentensteckbriefen und Leitungssatz-Schaltpläne durch das erfindungsgemäße Entwicklungssystem dokumentiert werden.

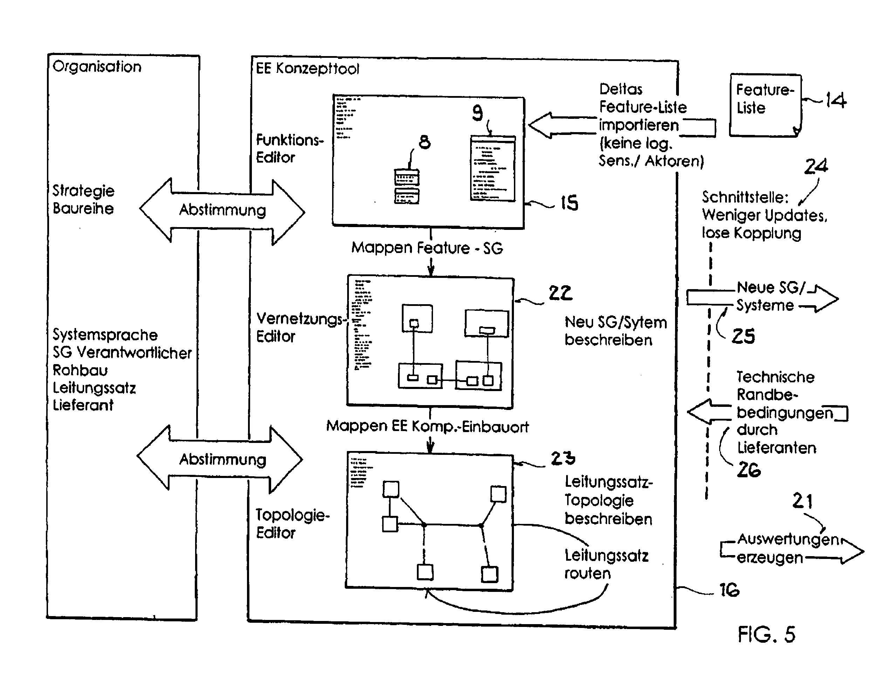

In Fig. 5 sind nun die einzelnen Verfahrensschritte während der Herstellung des komplexen technischen Systems im Verkehrsmittel dargestellt. Dabei kann das Gesamtsystem das komplette Fahrzeug in seiner elektrischen/elektronischen Ausprägung darstellen oder eben nur einen Teil davon, beispielsweise eine Motorsteuerung. Zunächst wird über die Benutzeroberfläche 7 bezogen auf eine Baureihe eine Strategie festgelegt, bei der notwendige Merkmale und Funktionen der EE-Gesamtarchitektur, die entwickelt werden muss, festgelegt wird. Es wird beispielsweise die Systemsprache festgelegt, dazu gehört entweder die Metasprache, mit der das Modell technisch beschrieben wird oder die Programmierungssprache, in der die auf den Steuergeräten ablauffähigen Programme erstellt werden sollen. Es werden aus dem CAD-System die mechanischen und bemaßungstechnischen Erfordernisse für den Rohbau des Verkehrsmittels übernommen und bei dem Verfahren zur Herstellung eines komplexen Systems berücksichtigt. Schließlich werden noch Merkmale und Funktionen des Leitungssatzes festgelegt und außerdem jeder Baugruppe der Lieferant zugeordnet, so dass Schnittstellen im Gesamtarchitekturmodell vorgesehen werden können, um später das Entwicklungsteilmodell mit den durch das Verfahren vorgegebenen Schnittstellen an die einzelnen Lieferanten weiterzugeben, so dass diese das entwickelte EE-Architektursystem herstellen können, welches dann aufgrund der exakt definierten Schnittstellen später in das EE-Gesamtarchitektursystem des Verkehrsmittels eingepasst werden kann. Das erfindungsgemäße Entwicklungssystem 16 weist neben dem Funktionseditor, in dem die Funktionen den einzelnen Baugruppen zugeordnet werden können, einen Vernetzungseditor 22 auf, in dem die Vernetzung zwischen den einzelnen Komponenten umgesetzt wird und einen Topologieeditor 23, in dem nach der Zuordnung der einzelnen Komponenten und Baugruppen an die Bauräume der Leitungssatz geroutet wird, d. h. in Bezug auf Länge und Verlegung in den Bauräumen optimiert wird. Der Leitungs-Router ist ein 3D-Router, der unter Berücksichtigung der Bemaßung des Rohbaus der Fahrzeugkarosserie die optimale Leitungsverlegung errechnen kann. Das erfindungsgemäße Verfahren stellt außerdem Schnittstellen 24 bereit, über die Veränderungen im Gesamtarchitekturmodell eingebracht werden können, wie beispielsweise die nachträgliche Einführung neuer Steuergeräte bei 25 oder Übernahme der Informationen bzgl. der Merkmale und Funktionen einzelner Komponenten beim Zulieferer 26. Das Verfahren wertet die vielfältigen Daten entsprechend der vorgegebenen Funktionen und Merkmale bzw. der vorgegebenen Komponenten aus und es werden Dokumentationsinformationen 21 erzeugt und es lassen sich Merkmalslisten 14 nachträglich neu einlesen und verändern.

Der Vorteil des vorliegenden Systems bzw. des vorliegenden Verfahrens besteht darin, dass ein EE-Gesamtarchitekturmodell modelliert wird entsprechend mit den Merkmalen und Funktionen und auch Topologien komplett durchgängig umgesetzt wird und dass bei Veränderungen im Entwicklungsprozess die unterschiedlichen Abhängigkeiten mit Hilfe mathematischer und physikalischer Funktionen definiert und beschrieben werden, so dass automatisch beim Zusammenlegen zweier Komponenten zu einer Komponente die Vernetzungsschnittstellen und die notwendige Vernetzung berechnet wird und für jeden Entwickler zu jedem Zeitpunkt die Anforderungen an seine zu entwickelnden Baugruppen dargestellt werden.

## Patentansprüche

1. Verfahren zur Herstellung eines komplexen technischen Systems in einem Verkehrsmittel, bei dem in einem ersten Schritt für jede Komponente (8, 9) deren technische Komponentenzustände (14, 15) definiert werden und daraus ein Gesamtmodell erzeugt wird, in dem alle Zustände (14, 15) für alle Komponenten (8, 9) abgelegt sind, bei dem in einem weiteren Schritt für jede Komponente (8, 9) ein Einbauraum (17) innerhalb des Verkehrsmittels festgelegt wird und die elektronischen Bauteile der Komponente (8, 9) festgelegt werden, wobei daraus ein Gesamtarchitekturmodell (18) für die Elektronikarchitektur im Verkehrsmittel entsteht und jeder Komponente (8, 9) bestimmte elektrische/elektronische Bauteile, deren Einbauraum (17) und deren Komponentenzustände (14, 15) zugewiesen werden, **dadurch gekennzeichnet, dass** zusätzlich die elektrische Verkabelung (19) der elektrischen Bauteile (8, 9) der Komponenten und deren Schnittstellen festgelegt werden und dass für das Gesamtarchitekturmodell (18) bei Verlagerung einer Komponente (8, 9) in einen anderen Bauraum des Verkehrsmittels oder bei Änderung des Umfangs der Komponentenzustände (14, 15) einer Komponente die notwendigen Signalübertragungsvorgänge zwischen den Komponenten berechnet werden.

2. Verfahren zur Herstellung eines komplexen technischen Systems in einem Verkehrsmittel, bei dem in einem ersten Schritt für jede Komponente (8, 9) deren technische Komponentenzustände (14, 15) definiert werden und daraus ein Gesamtmodell (18) erzeugt wird, in dem alle Zustände (14, 14) für alle Komponenten (8, 9) abgelegt sind, bei dem in einem weiteren Schritt für jede Komponente (8, 9) ein Einbauraum (17) innerhalb des Verkehrsmittels festgelegt wird und die elektronischen Bauteile der Komponente (8, 9) festgelegt werden, wobei aus dem Gesamtmodell (18), den Einbauräumen (17) und der elektronischen Bauteile ein Gesamtarchitekturmodell (18) für die Elektronikarchitektur im Verkehrsmittel entsteht und jeder Komponente (8, 9) bestimmte elektrische/elektronische Bauteile, deren Einbauraum (17) und deren Komponentenzustände (14, 15) zugewiesen werden, **dadurch gekennzeichnet, dass** zusätzlich die elektrische Verkabelung der elektrischen Bauteile der Komponenten (8, 9) und deren Schnittstellen festgelegt werden und das Gesamtarchitekturmodell (18) im Grundriss des Verkehrsmittels dargestellt wird und dass das Gesamtarchitekturmodell (18) bei Verlagerung einer Komponente (8, 9) in einen anderen Bauraum des Verkehrsmittels oder bei Änderung des Umfangs der Komponentenzustände (14, 15) einer Komponente (8, 9) die bezüglich der architektonischen Anordnung der elektrischen Bauteile notwendigen Veränderungen berechnet bzw. optimiert werden.

3. Verfahren nach Anspruch 1 oder 2, **dadurch gekennzeichnet, dass** eine der Komponenten die Außenbeleuchtung des Verkehrsmittels ist, wobei im Gesamtarchitekturmodell (18) die Positionierung der Lichtquellen im Grundriss des Verkehrsmittels, die Positionierung der zugehörenden elektrischen Komponenten (8, 9) und Steuergeräte und die Verkabelung/Vernetzung (19) der Bauteile berechnet wird und dass die Vernetzungen in Bezug auf die elektrischen und/oder informationstechnischen Signale optimiert wird.

4. Verfahren nach einem der Ansprüche 1 bis 3, **dadurch gekennzeichnet, dass** für jedes Übertragungsmedium der Verkabelung, insbesondere ein Datenbus, Leitungen (19) u.a., ein Schwellwert für die Anzahl der zu übertragenden Signale vorgesehen wird und dass für jedes Übertragungsmedium die sich aus der momentanen Elektronikarchitektur (18) ergebenden Signale berechnet werden und dass bei überschreiten des Schwellwerts ein weiteres Übertragungsmedium erzeugt wird, ein alternativer Signalweg berechnet wird oder eine Fehlermeldung erzeugt wird.
